# EUROPÄISCHE PATENTSCHRIFT

(11) **EP 4 158 688 B1**
(45) Veröffentlichungstag und Bekanntmachung des Hinweises auf die Patenterteilung: **26.06.2024**
(21) Anmeldenummer: 21746398.3
(22) Anmeldetag: 13.07.2021
(51) Int. Cl.: H01L 23/367, H01L 23/40, H01L 25/065, H01L 25/07, H05K 7/20, F21S 2/00

(54) **ANORDNUNG ZUR KÜHLUNG EINES LEISTUNGSMODULS UND LEISTUNGSMODUL**
POWER MODULE AND DEVICE FOR COOLING A POWER MODULE
AGENCEMENT DESTINÉ AU REFROIDISSEMENT D'UN MODULE DE PUISSANCE ET MODULE DE PUISSANCE

(30) Priorität: 14.08.2020 EP 20191157
(43) Veröffentlichungstag der Anmeldung: 05.04.2023
(73) Patentinhaber: Siemens Aktiengesellschaft, 80333 München (DE)
(72) Erfinder: KÖGLER, Roman, 90403 Nürnberg (DE); LUFT, Alexander, 90427 Nürnberg (DE); ROPPELT, Bernd, 96173 Unterhaid (DE); SCHMENGER, Jens, 91301 Forchheim (DE); SCHWINN, Thomas, 91074 Herzogenaurach (DE)
(74) Vertreter: Siemens Patent Attorneys
(86) Internationale Anmeldenummer: PCT/EP2021/069525
(87) Internationale Veröffentlichungsnummer: WO 2022/033789

(56) Entgegenhaltungen:
- EP-A1- 3 016 488
- CN-A- 102 062 325
- US-A1- 2012 043 652

## Beschreibung

Die Erfindung betrifft eine Anordnung zur Kühlung eines Leistungsmoduls gemäß dem Oberbegriff des Anspruchs 1 sowie ein Leistungsmodul gemäß dem Oberbegriff des Anspruchs 9.

Anordnungen zur Kühlung von Leistungsmodulen, also im Wesentlichen Kühlkörper, die in der Regel in derartigen Leistungsmodulen zur Kühlung von in so einem Leistungsmodul verbauten Leistungseinheiten angebracht sind, werden heutzutage üblicherweise mittels Schrauben am Gehäuse des Leistungsmoduls befestigt. Wie beispielsweise aus der nachveröffentlichten EP Anmeldung 20183215.1 bekannt, werden die auf dem Kühlkörper verbauten Leistungseinheiten, beispielsweise so genannte "In-sulated-Gate-Bipolar-Transistor"-, IGBT-Module ebenfalls durch Schrauben auf dem Kühlkörper angebracht. Der Kühlkörper benötigt also diverse Bohrungen, Ausbrüche und Gewindebohrungen zur Befestigung.

Dies hat Auswirkungen auf die Konstruktion des Kühlkörpers. Damit die Schraubverbindung eine notwendige Festigkeit aufweist, müssen Gewindebohrungen entsprechend viele Gewindegänge besitzen - es sind also gewisse Mindestdicken, beispielweise der Kühlkörperwurzel nötig.

Für die Befestigungsbohrungen zur Befestigung des Kühlkörpers KK im Gehäuse, muss Platz auf dem Kühlkörper vorgesehen werden. Dieser Platz befindet sich beispielsweise in Laschen seitlich an der Kühlkörperwurzel, da eine Befestigung an den Rippen nicht möglich ist. Es ist auch bekannt, dass alternativ zusätzliche verstärkte Rippen, also Rippen, die für den genannten Zweck mit einer Mindestdicke beaufschlagt sind, benötigt werden.

Die Konstruktion des Kühlkörpers geschieht also nicht nur aus thermischen Gesichtspunkten, sondern es muss eine Reihe an Anforderungen für die Befestigung berücksichtig werden.

Derzeit ist es so, dass ein Kompromiss zwischen Thermik und Mechanik in Kauf genommen werden muss. Wie zuvor schon beschrieben werden oft zusätzliche Laschen oder dickere Rippen zur Befestigung am Kühlkörper angebracht. Im Falle eines Strangpresskühlkörpers werden diese beispielsweise in der Kontur des Werkzeugs berücksichtigt. Nachteilig hierbei ist, dass dadurch ein Umriss entsteht, welcher über die gesamte Kühlkörperlänge verläuft. Nicht benötigte Bereiche müssen im Anschluss wieder abgefräst werden, so dass zusätzliche Arbeitsschritte und somit Kosten entstehen.

Ferner wird, um eine gewisse Dicke der Kühlkörperwurzel im Bereich der Gewindebohrungen zu erreichen, ohne die komplette Kühlkörperwurzel unnötig zu verdicken, auch partiell an der Stelle der Leistungseinheit die Kühlkörperwurzel überfräst wird, was die gleichen nachteiligen Folgen, also zusätzliche Arbeitsschritte und Kosten zur Folge hat.

Im Falle von Druckgusskühlkörpern ist es bekannt, dass diese zwar so gestaltet werden können, dass sie schon ganze Gehäuseteile beinhalten, so dass die Schraubstellen an thermisch unkritische Positionen wandern; allerdings sind die Werkzeuge für solche Kühlkörper sehr kompliziert und teuer. Zudem lassen sich Änderungen nachträglich nur sehr schwer einbringen. Die Kontaktfläche zur Leistungseinheit muss darüber hinaus zur Erstellung der benötigten Oberflächengüte dennoch überfräst werden.

Schließlich werden Schraubstellen für die Leistungseinheit und die mit ihnen verbundenen Nachteile bei diesen Kühlkörpern weiterhin benötigt.

Aus der CN102062325 ist eine Anordnung zur Kühlung eines LED Straßenlampen Moduls in einem Gehäuse bekannt.

Aus der US 2012/0043652 A1 ist ein Halbleiter-Leistungsmodul mit einem aktiven Element und einem passiven Element, die als Halbleiterelemente dienen, bekannt, wobei ein erstes Wärmerohr vorgesehen ist, um das aktive Element, das passive Element und eine Kühlrippe, die auf einem zweiten Wärmerohr angeordnet sind, zusammen zwischen sich und dem zweiten Wärmerohr einzuschließen.

Vor diesem Hintergrund ist es eine Aufgabe der vorliegenden Erfindung, eine Lösung anzugeben, die den erforderlichen Bauraum von Leistungsmodulen verringert sowie eine Entwärmung verbessert und die Nachteile des Standes der Technik überwindet.

Die Aufgabe wird erfindungsgemäß durch die Anordnung zur Kühlung eines Leistungsmoduls gemäß Oberbegriff des Anspruchs 1 durch dessen kennzeichnende Merkmale gelöst, sowie durch das Leistungsmodul gemäß dem Oberbegriff des Anspruchs 9, durch dessen kennzeichnende Merkmale gelöst.

Bei der erfindungsgemäßen Anordnung zur Kühlung eines Leistungsmoduls mit mindestens einer Leistungseinheit in einem Gehäuse aufweisend mindestens einen Kühlkörper, weist die Anordnung zur Kühlung mindestens eine Kühlkörperabdeckung auf, wobei zumindest ein Teil des Leistungsmoduls, insbesondere das Gehäuse, zumindest ein Teil des Kühlkörpers und/oder zumindest ein Teil der Kühlkörperabdeckung derart ausgestaltet ist, dass der Kühlkörper nach Anbringen der Kühlkörperabdeckung durch Zusammenwirken der Ausgestaltung von Kühlkörper, Kühlkörperabdeckung und/oder Gehäuse, insbesondere durch Klemmung, im Gehäuse fixiert ist.

Die erfindungsgemäße Anordnung zur Kühlung zeichnet sich unter anderem dadurch aus, dass mit ihr weitestgehend auf Verbindungen, insbesondere durch direkte Verschraubungen, der genannten Elemente verzichtet werden kann, welche negativen Einfluss auf die thermischen Eigenschaften des Kühlkörpers haben, die zur Wärmeableitung ("Entwärmung") beitragen.

Das erfindungsgemäße Leistungsmodul zeichnet sich dadurch aus, dass es eine erfindungsgemäße Anordnung bzw. eine seiner Ausgestaltungen und Weiterbildungen umfasst.

Hierdurch trägt er zur Implementierung und mutatis mutandis damit zur Realisierung der im Zusammenhang mit der Anordnung genannten Vorteile bei.

Weitere vorteilhafte Ausgestaltungen und Weiterbildungen der Erfindung sind durch die Unteransprüche angegeben.

Die in Bezug auf die Anordnung nachstehend angeführten Vorteile und bevorzugten Ausgestaltungen lassen sich dabei sinngemäß auf das erfindungsgemäße Leistungsmodul und seine sich mit den Ausgestaltungen der umfassten Anordnung ergebenden bevorzugten Ausgestaltungen übertragen.

Bei einer Ausgestaltung der Erfindung ist die erfindungsgemä-ße Anordnung derart ausgestaltet, dass die Leistungseinheit mittels Stoffschluss, insbesondere durch Kleben, Löten und/oder Sintern, auf dem Kühlkörper fixiert ist. Hierdurch wird erreicht, dass keine oder zumindest nahezu keine Schraubverbindungen mit der Leistungseinheit derart erforderlich sind, dass der Kühlkörper in seiner Wärmeableitungsleistung, insbesondere durch Verdickungen zur Führung und/oder Aufnahme der Schrauben bzw. der Gewinde, eingeschränkt wird. Das heißt, unter anderem hierdurch wird eine effektivere Ausgestaltung und somit Nutzung des Kühlkörpers, beispielsweise durch eine dann umsetzbare Verlängerung der Rippen oder Erhöhung der Rippenanzahl, möglich.

Eine Ausgestaltung bzw. Weiterbildung ist dadurch gegeben, dass die Anordnung derart gebildet ist, dass die Ausgestaltung zumindest teilweise als zumindest teilweiser Formschluss und/oder Kraftschluss von Kühlkörper, Kühlkörperabdeckung und/oder Gehäuse realisiert ist. Durch einen derartigen Formschluss wird der erfindungsgemäße Ansatz, die Kühlung effektiv und platzsparend zu gestalten und hierfür weitestgehend möglichst ganz auf Schraubverbindungen zu verzichten, unterstützt, da erfindungsgemäß geeignet ausgeformte Teile durch ihr ineinandergreifen für ein Fixieren der einzelnen Teile sorgen kann. Hierzu wird erfindungsgemäß bevorzugt weitgehend die bestehende Form der Teile beibehalten, insbesondere die des Kühlkörpers, da erfindungsgemäß die Wärmeableitungsmöglichkeiten eines Kühlkörpers ausgereizt werden sollen, ferner sollen dabei auch nach Möglichkeit die Ausmaße der einzelnen Teile bzw. der gesamten Anordnung so klein wie möglich gehalten werden.

Alternativ oder ergänzend kann die erfindungsgemäße Anordnung derart weitergebildet sein, dass für den Formschluss und/oder Kraftschluss vorzugsweise bei der Kühlkörperabdeckung (NKKA) Erhebung (BS) gebildet sind, die im Kühlkörper (NKK) und/oder im Gehäuse zur Aufnahme der Erhebung geformten Aussparungen greifen und/oder vice versa. Durch eine solche Ausgestaltung kann die genannten Rahmenbedingungen - Ausreizung der Wärmeableitungskapazitäten des Kühlkörpers und Minimierung der Raumforderung - eingehalten und zugleich eine stabilere Fixierung gewährleistet werden.

Als weitere Ergänzung oder alternative Ausgestaltung ist die erfindungsgemäße Anordnung derart ausgestaltet, dass der Formschluss und/oder durch Ausformung mindestens einer eines Schnapphakens in der Kühlkörperabdeckung und im Kühlkörper und/oder im Gehäuse als Aussparung ausgestaltet ist und vice versa. Schnapphaken haben durch das Einrasten für eine nicht ohne Weiteres auftrennbare Fixierung und können erfindungsgemäß ebenfalls gemäß den Rahmenbedingungen ausgeformt sein. Ist die Aussparung im Kühlkörper vorgesehen, dann kann Kühlkörperabdeckung und Kühlköper als kompaktes/fixiertes Gebilde ins Gehäuse montiert werden. Ist dagegen ein endgültiges Fixieren der Elemente bei der Montage ins Gehäuse angedacht, kann alternativ oder ergänzend die Aussparung im Gehäuse angebracht sein.

Bei einer weiteren Ausgestaltung der erfindungsgemäßen Anordnung ist die Kühlkörperabdeckung und/oder der Kühlkörper derart ausgestaltet, dass nach Anbringen im Leistungsmodul mindestens ein Kanal zur Luftstromführung ausgebildet ist, so dass ohne weitere Raumforderung die Kühlungsleistung des Kühlkörpers im Sinne der Erfindung weiter verbessert wird.

Bevorzugt wird die erfindungsgemäße Anordnung den gleichen Effekt erzielen, wenn sie zumindest derart ausgestaltet ist, dass als Ausformung des Kanals die Kühlkörperabdeckung und/oder der Kühlkörper derart ausgestaltet ist, dass zumindest zwischen mindestens einer äußersten Kühlrippe des Kühlkörpers und der Kühlkörperabdeckung ein Abstand ausgebildet ist, der derart ausgestaltet ist, dass entlang der Rippe, ein insbesondere durch einen Lüfter zugeführter Luftstrom zur Kühlung geführt wird.

Ein weiterer durch die Erfindung gegebener Vorteil, nämlich, dass der Einbau vereinfacht wird, verstärkt sich bzw. kann bewusst noch weiter optimiert werden, wenn die erfindungsgemäße Anordnung derart ausgestaltet ist, dass der Formschluss zumindest teilweise derart ausgestaltet ist, dass Kühlkörper, Kühlkörperabdeckung und/oder Gehäuse beim Einbau zumindest teilweise mechanisch geführt werden.

Im Folgenden wird die Erfindung anhand der in den Figuren dargestellten Ausführungsbeispiele näher beschrieben und erläutert.

Es zeigen:
- FIGUR 1: eine dreidimensionale schematische Darstellung einer Anordnung von Leistungseinheiten auf einem Kühlkörper gemäß Stand der Technik,
- FIGUR 2: eine dreidimensionale schematische Darstellung einer Ausgestaltung eines Leistungsmoduls gemäß Stand der Technik,
- FIGUR 3: eine dreidimensionale schematische Darstellung einer Ausgestaltung einer erfindungsgemäßen Anordnung,
- FIGUR 4: eine dreidimensionale schematische Darstellung einer Ausgestaltung eines erfindungsgemäßen Kühlkörpers inklusive Leistungseinheiten,
- FIGUR 5: eine dreidimensionale schematische Darstellung eines Ausschnitts der erfindungsgemäßen Anordnung im Vollschnitt.

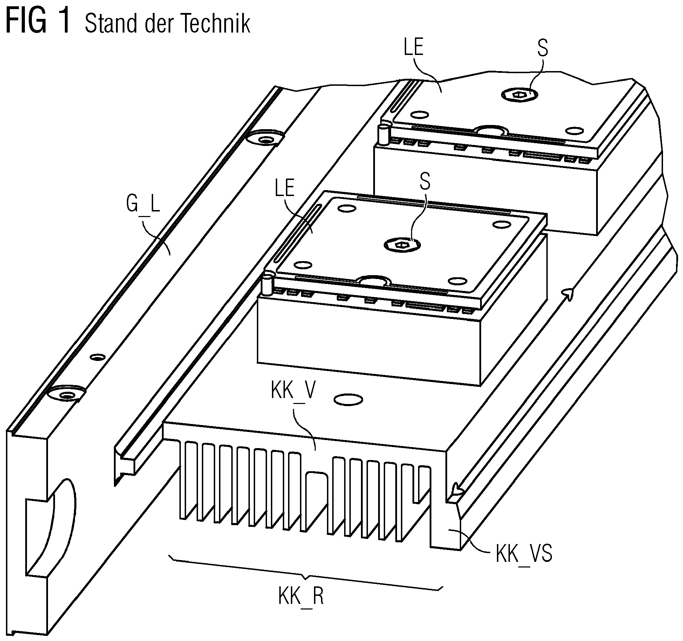

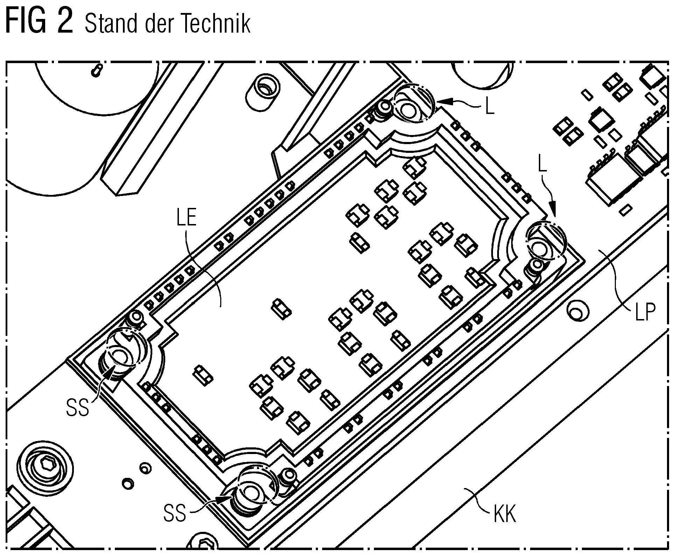

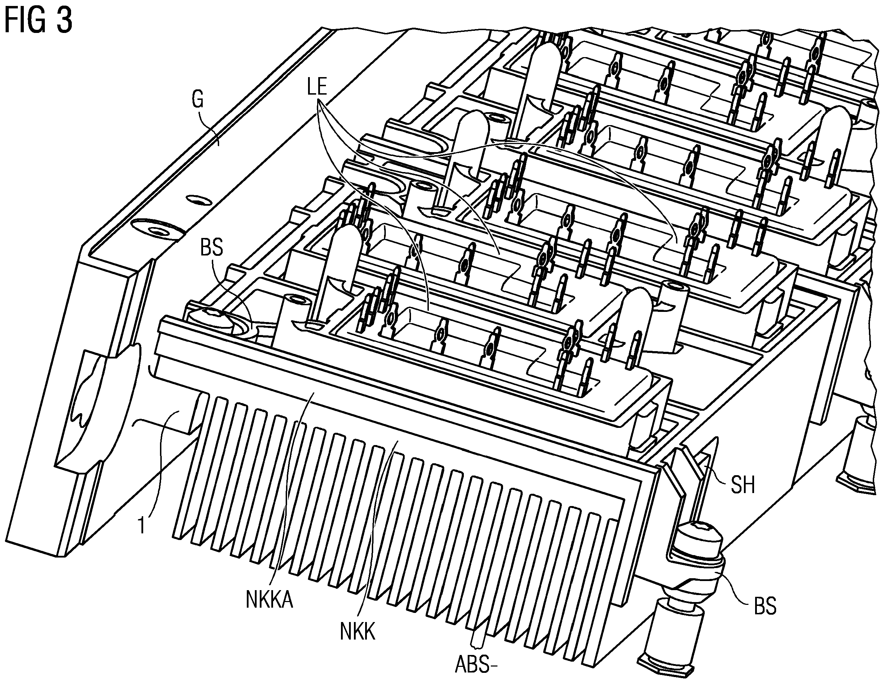

Bei den im Folgenden, ausgehend von dem in FIGUR 1 und FIGUR 2 dargestellten Stand der Technik, in FIGUR 3 bis FIGUR 5 erläuterten Ausführungsbeispielen, handelt es sich um bevorzugte Ausführungsformen und Weiterbildungen der Erfindung.

Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind.

Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

In der den Stand der Technik darstellenden FIGUR 1 ist ein Aufbau zur Ableitung von Wärme ("Entwärmung") von zwei Leistungseinheiten LE zu erkennen, die jeweils mit einer Befestigungsschraube S auf einen Kühlkörper KK fixiert sind.

Zur Befestigung mittels der Befestigungsschrauben ist, wie in der FIGUR 1 dargestellt, der Kühlkörper KK mittig mit einer Verstärkung KK_V versehen, die als lokale Aufdickung mittig entlang der so genannten Kühlkörperwurzel über die gesamte Länge des Kühlkörpers KK verläuft. Diese Aufdickung dient zur Führung der Schrauben S, die oberhalb der Leistungseinheit LE eingeführt werden und in die in den Kühlkörper KK ausgeformten Gewinde greifen. Dies ist auch der Grund der Aufdickung, denn um eine erforderliche Festigkeit (Drehmoment) der Schraubverbindung herzustellen, müssen genügend Gewindegänge vorhanden sein. Hierfür ist die Kühlkörperwurzel nicht dick genug und sie muss an der Schraubstelle verstärkt werden.

Wie zu erkennen ist, führt dies entlang der Verstärkung zu einer Abstandsänderung von an der Kühlkörperwurzel ausgebildeten Kühlkörperrippen KK_R. Dies wiederum hat zur Folge, dass es zu einer Beeinträchtigung der Kühlleistung kommt, da dieser Abstand gleichbedeutend ist mit weniger Kühlrippen KK_R, die hier nicht ausgebildet werden konnten und somit auch nicht thermisch genutzt werden können.

Das Gleiche gilt für die Verstärkung KK_VS der Rippe, die auf der rechten Seite des Kühlkörpers KK zu erkennen ist. Diese Verdickung der Rippe KK_V ist zur Befestigung des Kühlkörpers KK an einem Gehäuse, welches von unten an den Kühlkörper KK geschraubt wird. Durch diese Verdickung verändert sich die Effektivität des Kühlkörpers KK bzw. der Beitrag zur Kühlung je Rippe.

In der FIGUR 1 sieht man zudem seitlich auf der linken Seite, dass eine Gehäuserückwandlasche G_L angebracht ist, welche der Befestigung von Seitenblechen dient. Hierzu weist die Lasche G_L, die am Kühlkörper KK ausgeformt ist, ebenfalls Schraubstellen auf, um die Seitenwand oder weitere Gehäuseteile an der Gehäuserückwand zu befestigen. Dies muss in aufwändiger Weise gefräst werden. Zum Abwärmetransport ist diese Gehäuserückwandlasche G_L nur noch minimal nutzbar.

Zusammenfassend lässt sich also feststellen, dass so eine Anordnung gemäß Stand der Technik neben der Beschränkung der Entwärmung durch die Befestigungsmaßnahmen auch zu einem komplexen Gebilde des Kühlkörpers und somit zu einem kostenaufwändigen Herstellungsprozess führen.

Üblicherweise befinden sich zudem in unmittelbarer Nähe zum Kühlköper eine oder mehrere Leiterplatten zur Ansteuerung und Kontaktierung der zu kühlenden Leistungseinheit(en), wie den Leistungseinheiten LE.

Dieser aus dem Stand der Technik bekannte Vorgang, ist in der FIGUR 2 dargestellt. Bei so einem Ansatz gemäß dem Stand der Technik wird die Leistungseinheit LE zuerst auf die Leiterplatte LP montiert, bevor sie auf den Kühlkörper KK geschraubt wird - dies erfolgt beispielsweise beim Einlöten oder Einpressen. Hierzu müssen in der Regel in der Leiterplatte LP relativ große Löcher L vorgesehen werden, durch die später noch ein Schraubwerkzeug passt, um die Leistungseinheit LE dann am Kühlkörper KK festschrauben zu können.

Diese Löcher L in der Leiterplatte sind allerdings nachteilig, da nicht nur der Platz für das Loch auf der Leiterplatte zur Verfügung gestellt werden muss, sondern sich durch das Loch L zwischen den einzelnen Leiterplatten-Lagen Luft- und Kriechstrecken verkürzen, so dass Bauteile und Kupferzüge im Abstand zu den Löchern L platziert werden müssen und somit ein gewisser Umfang um das Loch L zusätzlich nicht mehr layouttechnisch genutzt werden kann. Dies führt zur der benötigten Leiterplattenfläche und hieraus folgend meist zur Vergrö-ßerung der Komponenten.

In FIGUR 3 ist nun eine schematische Darstellung einer ersten Ausgestaltung einer Anordnung gemäß der Erfindung zu sehen. Zu erkennen ist, dass das Problem mit der Befestigung eines Kühlkörpers im Gehäuse erfindungsgemäß unter anderem durch eine gemäß Erfindung gebildete beispielhaft aus dem möglichen Formenschatz gemäß der Erfindung herausgegriffene Kühlkörperabdeckung NKKA gelöst wird. Diese Abdeckung NKKA ist gemäß der Erfindung derart ausgestaltet, dass sie nicht nur zur erfindungsgemäßen Abdeckung des Kühlkörpers NKK gemäß Erfindung genutzt wird, sondern auch zur Führung des Luftstromes verwendet wird. Mit dieser Ausgestaltung wird also eine Lösung für eine Luftstromführung, wie sie oft in solchen Anordnungen vorgesehen ist, bereitgestellt. Es ist also kein weiteres Bauteil notwendig. Die erfindungsgemäße Abdeckung ist also aufwandsarm und platzsparend eingesetzt.

Erfindungsgemäß ist diese Kühlkörperabdeckung NKKA so gestaltet, dass sie sich formschlüssig um den Kühlkörper NKK schmiegt, so dass dieser sich dann gewissermaßen indirekt über die Abdeckung NKKA, insbesondere durch Klemmung, gehalten wird. Damit ist der Kühlkörper NKK gemäß Erfindung innerhalb des Gerätes fixiert.

Bei einer alternativen oder ergänzenden Weiterbildung ist wie in FIGUR 3 zu erkennen, die erfindungsgemäße Abdeckung NKKA derart geformt, dass der erfindungsgemäße Kühlkörper NKK von der Abdeckung NKKA auf die Schulter der Gehäuserückwand G aufgepresst wird, wie durch 1 schematisch angedeutet ist.

Dabei kann auch der Kühlkörper NKK gemäß Erfindung derart weitergebildet sein, dass auch er geformt ist, um den Formschluss und/oder Kraftschluss zu begünstigen und/oder die Fixierung, insbesondere durch Halten und/oder durch Klemmung, zu ermöglichen. Alternative Ausgestaltungen der Erfindung kommen allerdings auch ohne solche Ausprägungen des Kühlkörper NKK aus. Jedoch wird der erfindungsgemäße Kühlkörper NKK sich dadurch auszeichnen, dass er keine Veränderungen, wie zum Beispiel Verdickungen, aufweisen wird, die für eine Befestigung notwendig sind und zu Lasten von Kühlrippen oder anderen die Kühlung bereitstellenden Maßnahmen geht.

Mit oder ohne solche Ausgestaltungen, erfolgt die Befestigung erfindungsgemäß indirekt über die Abdeckung. Das heißt, die erfindungsgemäße Kühlkörperabdeckung NKKA drückt den Kühlkörper NKK ans Gehäuse G. Dies erfolgt erfindungsgemäß ohne zusätzliche Befestigungsmittel zwischen Kühlkörper NKK und Gehäuse, wie Schrauben, die sich hinsichtlich der Kühlungsleistung, also im Endeffekt thermisch negativ, auswirken.

Als Weiterbildung hierzu sind Befestigungsstellen BS in der FIGUR 3 gezeigt, die aus der Kühlkörperabdeckung NKKA ausgeformt sind und in entsprechende Gegenstücke, beispielsweise am Gehäuse und/oder des Kühlkörpers NKK greifen, wobei die Gegenstücke hierzu derart ausgestaltet sind, dass die Befestigungsstellen BS in entsprechend ausgeformte Stellen des Gegenstücks, insbesondere formschlüssig, greifen, so dass unter anderem hierdurch der erfindungsgemäße Kühlköper NKK indirekt im Gehäuse des Leistungsmoduls gehalten wird.

Die Befestigungsstellen BS sind im gezeigten Fall Gewindebuchsen im Gehäuse bzw. Gewindebohrungen in der Gehäuserückwand und im Gegenstück Ausformungen in der Kühlkörperabdeckung. Dieses Ausführungsbeispiel hat den Vorteil, dass bereits bestehende Ausformungen in "Standardteilen" wie dem Gehäuse nicht verändert werden müssen, um zur erfindungsgemäßen Verbindung beizutragen. Hier wird lediglich die erfindungsgemäße Kühlkörperabdeckung unter Berücksichtigung vorhandener Ausformungen des/der Gegenstücks/Gegenstücke entsprechend ausgeformt. Der Produktionsaufwand und/oder die Produktionskosten können hierdurch gesenkt werden.

Als eine Weiterbildung kann es angedacht sein, die Stellen für das Festschrauben mittels Schrauben SS für Leistungseinheiten LE zu ersetzen, in dem die jeweilige Leistungseinheit LE direkt auf den erfindungsgemäßen Kühlkörper NKK lötet, klebt oder sintert.

Die beiden oben genannten Ausgestaltungen der Erfindung, formschlüssige und/oder kraftschlüssige Kühlkörperabdeckung NKKA und aufgelöteter Kühlkörper NKK, erlauben sowohl einzeln angewandt als auch in Kombination alle Befestigungspunkte am aus dem Stand der Technik bekannten Kühlkörper KK zu eliminieren und so den erfindungsgemäßen Kühlkörper NKK zu schaffen, der auf thermische Aspekte ausgelegt ist und vor Allem ihn diesbezüglich auch zu optimieren.

Es ist natürlich auch möglich, bei Verwendung von nur einem der beiden Ausgestaltungen oder auch beiden in Kombination die Schraubstellen und/oder Befestigungspunkte, zumindest zu minimieren und nicht ganz wegfallen zu lassen, falls für einzelne Implementierungen einzelne Verschraubungen unumgänglich sei sollten

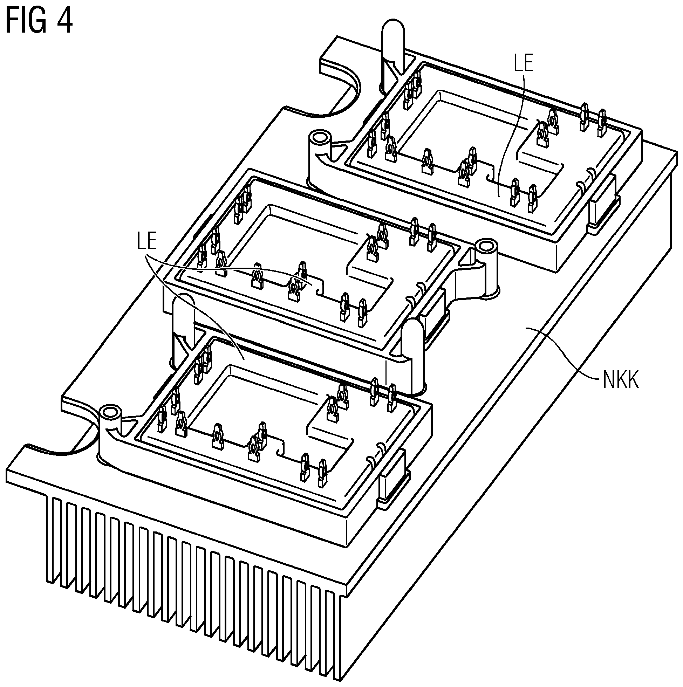

Grundsätzlich soll gemäß der Erfindung jedoch die Anzahl der Schrauben und/oder Befestigungspunkte vor Allem am Kühlkörper NKK wo es möglich ist auf Null reduziert werden, so dass eine wie in FIGUR 4 dargestellte Anordnung von Leistungseinheiten LE auf einem erfindungsgemäßen Kühlkörper NKK das Resultat ist, bei dem der Kühlkörper NKK keine für Verschraubungen vorgesehenen Manipulationen aufweist und die Leistungseinheiten LE durch Löten oder mittels Sintern auf den Kühlkörper NKK aufgebracht ist.

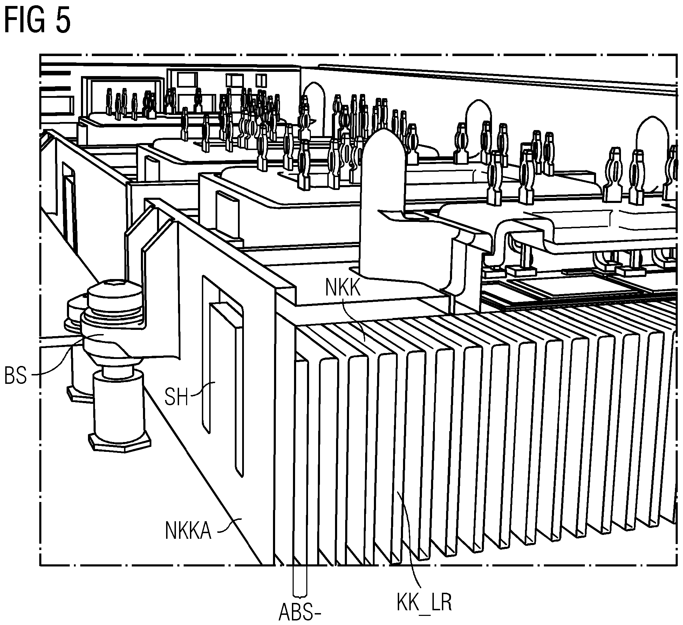

Eine weitere Ausgestaltung bzw. Weiterbildung der erfindungsgemäßen Kühlkörperabdeckung NKKA wird sichtbar, wenn sie wie in der FIGUR 5 der Fall in Vollschnitt dargestellt ist und betrachtet wird. Dabei wird sichtbar, dass die erfindungsgemäße Kühlkörperabdeckung gemäß dem gezeigten Ausführungsbeispiel so gestaltet, dass das Wegfallen von aufgedickten Rippen zur Befestigung derart genutzt wird, dass die erfindungsgemäße Kühlkörperabdeckung NKKA so gestaltet wird, dass ein Abstand ABS zur letzten Kühlrippe KK_LR entsteht, wie es in der FIGUR 5 durch die Darstellung im Vollschnitt zu erkennen ist.

Hieraus ergibt sich ein weiterer, deutlicher Vorteil, dass der Luftstrom eines Lüfters dadurch so eingeleitet werden kann, dass die letzte Rippe von beiden Seiten mit Luft umströmt wird und somit vollwertig zur Kühlung verwendet werden kann.

Weiterhin wird, durch die strömende Luft zwischen letzter Kühlrippe und Kühlkörperabdeckung NKKA, der Innenraum des Gerätes thermisch vom Kühlkörper NKK entkoppelt. Der Geräteinnenraum wird kühler. Die Lebensdauer dort befindlicher Bauelemente steigt, bzw. es können kostengünstigere Bauelemente verbaut werden.

Als eine weitere mögliche Weiterbildung ist in FIGUR 5 zudem noch zu erkennen, dass die erfindungsgemäße Kühlköperabdeckung NKKA noch mit einem Schnapphaken SH versehen ist, welcher der Befestigung der modifizierten Kühlkörperabdeckung NKKA am Kühlkörper dient. Solche Haken können natürlich auch alternativ oder ergänzend am Kühlkörper oder anderen Teilen der erfindungsgemäßen Anordnung vorgesehen sein, wobei das Gegenstück entsprechend für das arretieren des Schnapphakens SH ausgeformt ist bzw. der Schnapphaken so platziert und ausgeformt ist, dass er durch das Design des jeweiligen Gegenstücks bereits gegebene Ausbuchtungen arretiert wird.

Hierdurch wird einer der erfindungsgemäßen Gedanken möglichst wenig an den beteiligten Elementen zu verändern, insbesondere nichts, was vorteilhafte thermische Eigenschaften für die Kühlung hemmen könnte, Rechnung getragen.

Die Erfindung ist nicht auf die beschriebenen Ausgestaltungen und Weiterbildungen bzw. den beschriebenen Kombinationen beschränkt. Vielmehr werden alle sich ergebenden Varianten und Kombination, die von den Ansprüchen umfasst sind, als zur Erfindung gehörend betrachtet und auch bei einer Implementierung entsprechend berücksichtigt. Implementierungen werden insbesondere dann als erfindungsgemäß zu bewerten sein, wenn sie eine oder mehrere der folgenden Merkmale aufweisen:
1. Der Kühlkörper NKK wird nicht direkt am Gehäuse befestigt, sondern indirekt über die Kühlkörperabdeckung NKKA gehalten. Falls Schrauben zur Befestigung am Gehäuse genutzt werden, so haben sie keinen direkten Kontakt mit dem Kühlkörper NKK.
2. Die Leistungseinheit LE wird nicht auf dem Kühlkörper NKK verschraubt, sondern aufgelötet, "aufgesintert" und/oder geklebt.
3. Die Kombination aus den Merkmalen 1. und 2. und damit auch einen zumindest nahezu schraubstellenlosen Kühlkörper NKK.
4. Zwischen Kühlkörperabdeckung NKKA und letzter Rippe(n) KK_LR des Kühlkörpers KK besteht ein Spalt ABS, in dem der Luftstrom des Lüfters eingeleitet wird.

Ferner zeigen sich die folgenden erfindungsgemäßen Vorteile bzw. alternative und/oder ergänzende Ausgestaltungen/Weiterbildungen:
- Die Kühlkörperabdeckung NKAA kombiniert eine oder mehrere der folgenden Funktionen, wie beispielsweise die mechanische Befestigung des Kühlkörpers NKK, Luftleitung im Luftkanal, thermische Abschottung zum Innenraum, elektrische Isolation, insbesondere durch Vergrößerung der Luft- und Kriechstrecken, zwischen Kühlkörper NKK und Leistungselektronik, Führung beim Einbau des die Leistungseinheiten LE enthaltenden Leistungsmoduls in das Gerät und ist somit ein Bauteil für mehrere Funktionen.
- Der Kühlkörper NKK kann thermisch optimiert werden, so dass dieser entweder kleiner oder leistungsfähiger werden kann, so dass eine bessere Ausnutzung des Kühlkörpers NKK gewährleistet werden kann.
- Deutliche Steigerung der Kühlkörperrippen und somit Kühlleistung. Bei den dargestellten Ausgestaltungen ergeben sich durch die erfindungsgemäße Ausgestaltung in etwa +33 % mehr Rippen bei gleichem Einbauvolumen.
- Sehr einfach gestaltete und somit kostengünstige Kühlkörper NKK sind durch die Ausgestaltungen der Erfindung möglich. Somit einfache Strukturen und nicht zuletzt dadurch weniger Bearbeitungsschritte erforderlich.
- Kompaktere Geräte sind möglich.
- Löcher L in der Leiterplatte LP können minimiert werden und somit Leiterplattenfläche eingespart werden.
- Kosteneinsparung.
- Geringere Innenraumtemperatur.

## Patentansprüche

1. Anordnung zur Kühlung (NKAA, NKK) eines Leistungsmoduls mit mindestens einer Leistungseinheit (LE) in einem Gehäuse, aufweisend mindestens einen Kühlkörper (NKK),
**dadurch gekennzeichnet, dass**
die Anordnung zur Kühlung mindestens eine Kühlkörperabdeckung (NKKA) aufweist und zumindest ein Teil des Leistungsmoduls, insbesondere das Gehäuse, zumindest ein Teil des Kühlkörpers (NKK) und/oder zumindest ein Teil der Kühlkörperabdeckung (NKKA) derart ausgestaltet ist, dass der Kühlkörper (NKK) nach Anbringen der Kühlkörperabdeckung (NKKA) durch Zusammenwirken der Ausgestaltung von Kühlkörper (NKK), Kühlkörperabdeckung (NKKA) und/oder Gehäuse, insbesondere durch Klemmung, im Gehäuse fixiert ist, wobei die Ausgestaltung zumindest teilweise als zumindest teilweiser Formschluss und/oder Kraftschluss von Kühlkörper (NKK), Kühlkörperabdeckung (NKKA) und/oder Gehäuse realisiert ist und der Kraftschluss durch Ausformung mindestens einer Klemmung und /oder mindestens eines Schnapphakens (SH) in der Kühlkörperabdeckung (NKAA) und im Gehäuse und/oder Kühlkörper NKK als Aussparung ausgestaltet ist und vice versa.

2. Anordnung nach dem vorhergehenden Anspruch,
**dadurch gekennzeichnet, dass**
die Leistungseinheit (LE) mittels Stoffschluss, insbesondere durch Kleben, Löten und/oder Sintern, auf dem Kühlkörper (NKK) fixiert ist.

3. Anordnung nach dem Anspruch 1,
**dadurch gekennzeichnet, dass**
für den Formschluss und/oder Kraftschluss vorzugsweise bei der Kühlkörperabdeckung (NKKA) Erhebungen (BS) gebildet sind, die im Kühlkörper (NKK) und/oder im Gehäuse zur Aufnahme der Erhebungen geformten Aussparungen (BS) greifen und/oder vice versa.

4. Anordnung nach einem der vorhergehenden Ansprüche, **dadurch gekennzeichnet, dass** die Kühlkörperabdeckung (NKKA) und/oder der Kühlkörper derart ausgestaltet ist, dass nach Anbringen im Leistungsmodul mindestens ein Kanal zur Luftstromführung ausgebildet ist.

5. Anordnung nach einem der vorhergehenden Ansprüche, **dadurch gekennzeichnet, dass** als Ausformung des Kanals die Kühlkörperabdeckung (NKKA) und oder der Kühlkörper derart ausgestaltet ist, dass zumindest zwischen mindestens einer äußersten Kühlrippe des Kühlkörpers (NKK) und der Kühlkörperabdeckung (NKKA) ein Abstand ausgebildet ist, der derart ausgestaltet ist, dass entlang der Rippe ein, insbesondere durch einen Lüfter zugeführter Luftstrom, zur Kühlung geführt wird.

6. Anordnung nach einem der Ansprüche 1 bis 5,
**dadurch gekennzeichnet,**
**dass** der Formschluss zumindest teilweise derart ausgestaltet ist, dass Kühlkörper (NKK), Kühlkörperabdeckung (NKKA) und/oder Gehäuse beim Einbau zumindest teilweise mechanisch geführt werden.

7. Leistungsmodul mit mindestens einer Anordnung zur Kühlung (NKKA, NKK) mindestens einer Leistungseinheit (LE) nach einem der vorhergehenden Ansprüche.

## Claims

1. Arrangement for cooling (NKAA, NKK) a power module with at least one power unit (LE) in a housing, having at least one heat sink (NKK),
**characterized in that**
the arrangement for cooling has at least one heat-sink cover (NKKA), and at least a part of the power module, in particular the housing, at least a part of the heat sink (NKK) and/or at least a part of the heat-sink cover (NKKA) are/is configured in such a way that, after attachment of the heat-sink cover (NKKA), the heat sink (NKK) is fixed in the housing, in particular by way of clamping, through interaction of the configuration of heat sink (NKK), heat-sink cover (NKKA) and/or housing, wherein the configuration is realized at least partially as an at least partial form fit and/or force fit of heat sink (NKK), heat-sink cover (NKKA) and/or housing and the force fit is configured by way of formation of at least one clamp and/or at least one snap-action hook (SH) in the heat-sink cover (NKAA) and cutout in the housing and/or heat sink (NKK) and vice versa.

2. Arrangement according to the preceding claim,
**characterized in that**
the power unit (LE) is fixed on the heat sink (NKK) by means of material bonding, in particular by way of adhesive bonding, soldering and/or sintering.

3. Arrangement according to Claim 1,
**characterized in that**,
for the form fit and/or force fit, preferably at the heat-sink cover (NKKA), there are formed elevations (BS) which engage with cutouts formed in the heat sink (NKK) and/or in the housing for receiving the elevations (BS) and/or vice versa.

4. Arrangement according to one of the preceding claims, **characterized in that** the heat-sink cover (NKKA) and/or the heat sink are/is configured in such a way that, after attachment in the power module, at least one channel for air-stream guidance is formed.

5. Arrangement according to one of the preceding claims, **characterized in that**, as a formation of the channel, the heat-sink cover (NKKA) and/or the heat sink are/is configured in such a way that, at least between at least one outermost cooling rib of the heat sink (NKK) and the heat-sink cover (NKKA), there is formed a spacing which is configured in such a way that an air stream, supplied in particular by a fan, for cooling is guided along the rib.

6. Arrangement according to one of Claims 1 to 5, **characterized**
**in that** the form fit is at least partially configured in such a way that heat sink (NKK), heat-sink cover (NKKA) and/or housing are/is at least partially mechanically guided during installation.

7. Power module with at least one arrangement for cooling (NKKA, NKK) at least one power unit (LE) according to one of the preceding claims.

## Revendications

1. Dispositif de refroidissement (NKKA, NKK) d'un module de puissance avec au moins une unité de puissance (LE) dans un boîtier, présentant au moins un élément de refroidissement (NKK),
**caractérisé en ce que** le dispositif de refroidissement présente au moins un couvercle de l'élément de refroidissement (NKKA) et au moins une partie du module de puissance, en particulier le boîtier, au moins une partie de l'élément de refroidissement(NKK) et/ou au moins une partie du couvercle de l'élément de refroidissement(NKKA) est configurée de telle sorte que l'élément de refroidissement (NKK), après la mise en place du couvercle de l'élément de refroidissement(NKKA), est fixé par coopération de la forme de l'élément de refroidissement (NKK), du couvercle de l'élément de refroidissement (NKKA) et/ou du boîtier, en particulier par serrage, dans le boîtier, le dispositif étant réalisé au moins partiellement sous la forme d'une liaison par la forme et/ou d'une liaison par la force au moins partielle de l'élément de refroidissement (NKK), du couvercle de l'élément de refroidissement (NKKA) et/ou du boîtier, et la liaison par la force étant réalisée par la formation d'au moins un serrage et/ou d'au moins un crochet à déclic (SH) dans le couvercle de l'élément de refroidissement (NKKA) et dans le boîtier et/ou l'élément de refroidissement (NKK) sous la forme d'un évidement et vice versa.

2. Dispositif selon la revendication précédente,
**caractérisé en ce que** l'unité de puissance (LE) est fixée sur l'élément de refroidissement (NKK) au moyen d'une liaison par matière, notamment par collage, soudure et/ou frittage.

3. Dispositif selon la revendication 1,
**caractérisé en ce que**, pour la liaison par complémentarité de forme et/ou la liaison par adhérence, des saillies (BS) sont formées de préférence dans le couvercle de l'élément de refroidissement (NKKA), lesquelles s'engagent dans des évidements (BS) formés dans l'élément de refroidissement (NKK) et/ou dans le boîtier pour recevoir les saillies et/ou vice versa.

4. Dispositif selon l'une des revendications précédentes,
**caractérisé en ce que** le couvercle de l'élément de refroidissement (NKKA) et/ou l'élément de refroidissement est conçu de telle sorte qu'après le montage dans le module de puissance, au moins un canal est formé pour le guidage du flux d'air.

5. Dispositif selon l'une des revendications précédentes,
**caractérisé en ce que**, pour former le canal, le couvercle (NKKA) de l'élément de refroidissement et/ou l'élément de refroidissement est configuré de telle sorte qu'au moins entre au moins une ailette de refroidissement extérieure de l'élément de refroidissement (NKK) et le couvercle (NKKA) de l'élément de refroidissement est formé un espace qui est configuré de telle sorte qu'un flux d'air, en particulier amené par un ventilateur, est guidé le long de l'ailette pour le refroidissement.

6. Dispositif selon l'une quelconque des revendications 1 à 5,
**caractérisé en ce que** la liaison par complémentarité de forme est conçue au moins partiellement de telle sorte que l'élément de refroidissement(NKK), le couvercle de l'élément de refroidissement(NKKA) et/ou le boîtier sont guidés mécaniquement au moins partiellement lors du montage.

7. Module de puissance comportant au moins un dispositif de refroidissement (NKKA, NKK) d'au moins une unité de puissance (LE) selon l'une des revendications précédentes.
